# FASCICULE DE BREVET EUROPEEN

(11) **EP 0 862 182 B1**
(45) Date de publication et mention de la délivrance du brevet: **11.08.1999**
(21) Numéro de dépôt: 98400465.5
(22) Date de dépôt: 26.02.1998
(51) Int. Cl.: G11C 11/419

(54) **Procédé d'effacement d'une mémoire RAM statique et mémoire en circuit intégré associé**
Löschverfahren für statischen RAM-Speicher und zugehörige Speicherschaltung
Erasing method for a static RAM memory and associated integrated memory circuit

(30) Priorité: 28.02.1997 FR 9702454
(43) Date de publication de la demande: 02.09.1998
(73) Titulaire: STMicroelectronics S.A., 94250 Gentilly (FR)
(72) Inventeur: Hennebois, Brigitte c/o Cabinet Ballot Schmit, 94230 Cachan (FR); Monari, Jean-Yves c/o Cabinet Ballot Schmit, 94230 Cachan (FR)
(74) Mandataire: Ballot, Paul

(56) Documents cités:
- EP-A- 0 642 131
- US-A- 4 928 266

## Description

La présente invention concerne un procédé d'effacement d'une mémoire RAM statique et une mémoire en circuit intégré correspondante.

Les mémoires RAM statiques sont utilisées dans nombre d'applications à microprocesseur, notamment en traitement de données, pour contenir les données sur lesquelles on effectue des calculs ou autres traitements. Elles sont ainsi utilisées pour contenir temporairement des données. A la mise hors-tension, elles perdent leur contenu, à moins qu'elles ne soient associées à une source d'énergie (piles) de sauvegarde.

Les mémoires RAM statiques sont notamment utilisées dans les produits de type "smart card" pour lesquels on connaît le haut niveau de sécurité exigé. Ces mémoires permettent dans ces produits d'appliquer les différents calculs de chiffrement ou autres sur des données confidentielles.

On comprend alors qu'il ne doit pas pouvoir être possible de récupérer les données inscrites dans ces mémoires RAM statiques, pour empêcher toute exploitation à des fins frauduleuses.

Or même si ces mémoires sont "volatiles", on ne peut être certain que des données ne pourront pas être récupérées à la mise hors-tension, car ces données ne disparaissent pas instantanément. On a une certaine rémanence.

Ainsi, même si on détecte une anomalie quelconque au moyen de divers capteurs de sécurité prévus et des programmes sécuritaires associés (test de tension, fréquence, température, passivation...), la mise hors-tension du circuit peut ne pas suffire à empêcher la récupération frauduleuse de données sensibles dans ces mémoires.

Or, si il est possible à un système externe de commander l'effacement d'une mémoire RAM statique, en envoyant des signaux de commande externe sur la mémoire appropriés et en procédant adresse par adresse, cela est assez lent et le recours à une sécurité activée via des moyens externes n'est jamais satisfaisant en terme de lutte contre la fraude.

Dans l'invention, on a eu l'idée de permettre un effacement complet de la mémoire en interne.

Selon l'invention, cet effacement est matériel et non logiciel, pour un maximum de sécurité. Il est déclenché automatiquement, sans recours possible, par la détection d'évènements identifiés, comme la mise sous tension du circuit-intégré ou la détection d'une anomalie, assurant une sécurité maximum dudit circuit.

L'effacement global peut être obtenu en sélectionnant toutes les cellules de la mémoire et en activant des transistors qui tirent la sortie vers la masse. Mais on comprend qu'en pratique la consommation de courant induite par une telle opération d'effacement global pose problème. En effet, une ligne de bit de 128 cellules de mémoire RAM statique peut par exemple consommer jusqu'à 25 milliampères en effacement. Multiplié par le nombre de lignes de bit de la mémoire, on peut se retrouver avec une consommation inacceptable en pratique, selon la capacité totale de la mémoire. Si la mémoire a ainsi une capacité de 2 Kbytes, il faudrait environ 2 ampères pour assurer l'effacement global, instantané de la mémoire. Ce n'est pas réalisable.

Pour résoudre ce problème technique, l'invention propose une opération d'effacement séquentiel de la mémoire, obtenu en découpant la mémoire en groupes de cellules mémoire et en faisant se propager de manière contrôlée un signal d'effacement de groupe en groupe. L'effacement d'un groupe de cellule est alors activé quand l'effacement d'un groupe de cellules précédent est terminé. De cette manière on étale dans le temps la consommation de courant.

La dimension du groupe de cellules dépend de l'organisation du plan mémoire, de sa capacité, et de la consommation que l'on peut admettre. Du choix de cette dimension dépend directement le temps d'effacement total nécessaire, qui doit être le plus faible possible pour limiter au maximum la durée pendant laquelle des données pourraient encore être lues et récupérées.

Le groupe le plus petit que l'on peut utiliser facilement est une ligne de bit du plan mémoire, ou du demi-plan quand le plan mémoire est organisé en deux demi-plans, toutes les lignes de mot étant sélectionnées. Selon la capacité mémoire, le temps d'effacement total et la consommation admissible recherchés, le groupe peut correspondre à deux ou plusieurs lignes de bit dont on sélectionne simultanément toutes les cellules pour les effacer ensemble.

La propagation contrôlée du signal d'effacement est assurée par un circuit retardateur, placé entre chaque groupe de cellules, et dimensionné pour assurer un retard correspondant au temps d'effacement d'un groupe de cellules. De cette manière, la consommation du courant est étalée sur toute la durée d'effacement de la mémoire. A un moment donné, elle est égale au courant d'effacement d'un seul groupe de cellules.

D'autres caractéristiques et avantages de l'invention sont détaillés dans la description suivante, faite à titre indicatif et non limitatif et en référence aux dessins annexés dans lesquels :
- la figure 1 montre un exemple de réalisation d'une cellule de mémoire RAM statique en technologie CMOS;
- la figure 2 montre un exemple correspondant d'organisation d'une mémoire RAM avec une représentation schématique d'un mode de réalisation d'un effacement séquentiel selon l'invention et,
- la figure 3 montre un exemple de réalisation pratique dans une mémoire RAM statique pour mettre en oeuvre le procédé d'effacement selon l'invention.

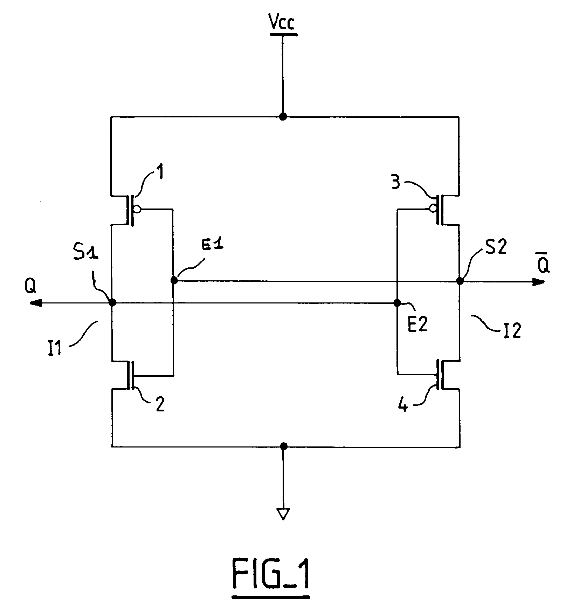

La figure 1 montre une cellule de mémoire RAM statique en technologie CMOS. Cette cellule comprend de manière classique deux inverseurs rebouclés I1 et I2, à transistors complémentaires.

Le premier inverseur I1 comprend ainsi un transistor MOS 1 de type P en série avec un transistor MOS 2 de type N, dont les grilles reliées ensemble forment l'entrée E1 de l'inverseur et dont les drains reliés ensemble forment la sortie S1 de l'inverseur I1.

Le deuxième inverseur I2 comprend un transistor MOS 3 de type P et un transistor MOS 4 de type N, dont les grilles reliées ensemble forment l'entrée E2 de l'inverseur et dont les drains reliés ensemble forment la sortie S2 de l'inverseur I2.

La sortie S1 du premier inverseur est connectée à l'entrée E2 du deuxième inverseur et forme la borne Q de la cellule mémoire. La sortie S2 du deuxième inverseur est connectée à l'entrée E1 du premier inverseur et forme la borne /Q de la cellule mémoire.

Le fonctionnement d'une telle cellule mémoire est bien connu. Pour écrire une donnée ("0" ou "1"), on présente l'information à écrire sur la borne Q de la cellule, c'est à dire sur l'entrée E2 du deuxième inverseur I2 et la sortie S1 du premier inverseur I1. Le deuxième inverseur I2 est dimensionné pour suivre rapidement le niveau d'entrée. Sa sortie S2, appliquée sur l'entrée E1 du premier inverseur permet à ce dernier de conforter son niveau en sortie S1 et il est dimensionné pour maintenir ce niveau en sortie. Pour lire l'information contenue dans la cellule mémoire, on sélectionne dans l'exemple les deux bornes Q et /Q de la cellule pour transmettre l'information contenue et son complémentaire vers un circuit amplificateur de sortie.

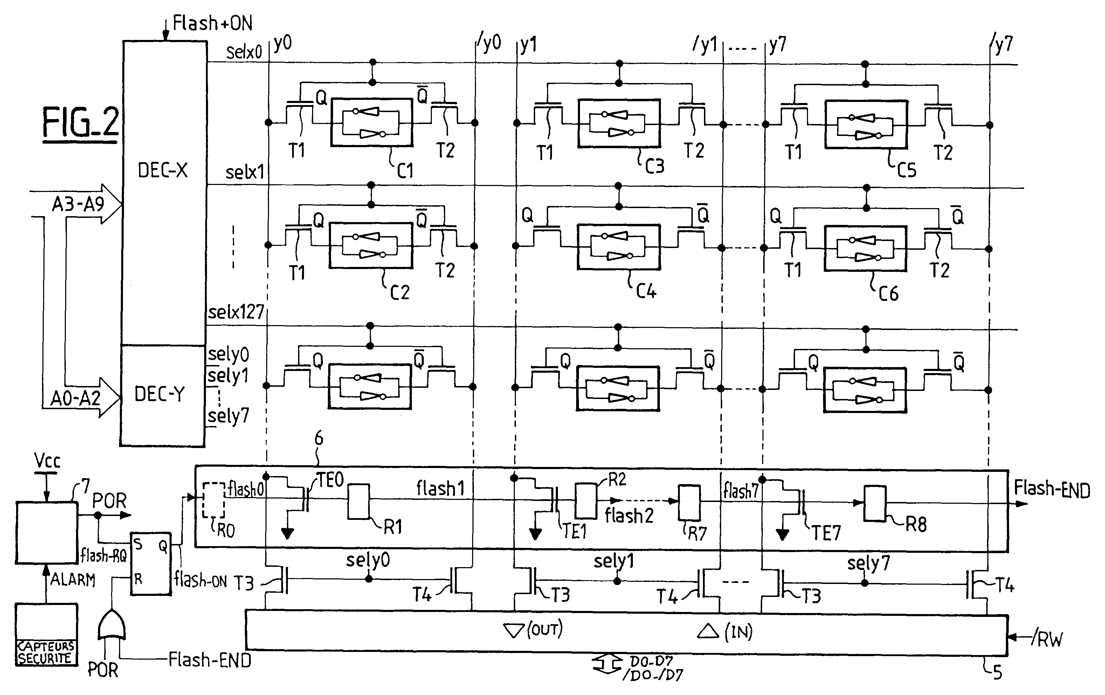

Un exemple d'organisation d'une mémoire RAM statique est représenté sur la figure 2. C'est une organisation matricielle en lignes de bit (y0 à y7) et lignes de mot (selx0 à selx127). Les cellules mémoires C1, C2.. sont schématisées par 2 inverseurs rebouclés.

Un transistor de sélection T1 est connecté entre la borne Q de chaque cellule, par exemple C1 et la ligne de bit associée, y0 dans l'exemple. Ce transistor de sélection est commandé sur sa grille par le signal de sélection de ligne de mot associé selx0 dans l'exemple. Quand ce signal de sélection est activé (dans l'exemple, quand il est à "1"), toutes les cellules associées à cette ligne de mot transmettent le niveau de leur borne Q sur la ligne de bit associée.

Dans l'exemple représenté, on a un deuxième transistor de sélection T2 connecté entre la borne /Q de chaque cellule et la ligne de bit complémentaire correspondante, /y0). Chaque ligne de bit et chaque ligne de bit complémentaire est connectée à un circuit 5 de lecture/écriture par un transistor de sélection associé noté T3 pour la ligne de bit et T4 pour la ligne de bit complémentaire. Ils sont commandés sur leur grille par le signal de sélection de ligne de bit correspondant, sely0 pour les lignes y0 et /y0, sel y1 pour les lignes y1 et /y1, ..., sel y7 pour les lignes y7 et /y7.

Le circuit 5 de lecture/écriture est connecté aux bus d'entrée/sortie de données, D0-D7 et /D0-/D7 dans l'exemple.

Les signaux de sélection de lignes de mot et de lignes de bit sont fournis par respectivement un décodeur de lignes de mot noté DEC-X et un décodeur de lignes de bit noté DEC-Y. En fonctionnement normal, ces décodeurs permettent la sélection d'une ligne de mot et d'une ou plusieurs lignes de bit, pour lire, écrire ou effacer un mot d'information. On retrouve alors sur la ligne de mot sélectionnée, (selx0 par exemple) la tension d'alimentation Vdd du circuit.

L'architecture représentée est simple, mais suffisante pour expliquer le principe de l'invention. D'autres architectures courantes sont possibles, notamment celles où le plan mémoire est divisé en deux demi-plans.

Selon l'invention, la mémoire comprend en outre des moyens 6 pour effacer toutes les cellules mémoires sur activation d'un signal de commande d'effacement flash-ON généré en interne.

Ces moyens 6 pour effacer comprennent un transistor d'effacement par groupe de cellules à effacer et des circuits retardateurs en série sur une ligne de propagation du signal de commande d'effacement flash-ON, chacun des circuits retardateurs étant placé entre deux groupes de cellules à effacer.

Dans l'exemple, un groupe de cellules correspond à une ligne de bit. La sélection d'un groupe de cellules particulier est alors obtenue en sélectionnant la ligne de bit correspondante, toutes les lignes de mot étant préalablement sélectionnées.

Pour permettre la sélection simultanée de toutes les lignes de mot, des moyens sont prévus dans le décodeur de lignes de mot DEC-X, qui permettent cette sélection globale simultanée sur activation d'un signal de commande, qui peut être, par exemple, le signal de commande d'effacement flash-ON. Le décodeur DEC-X peut par exemple comprendre des circuits logiques aptes à imposer un état actif sur toutes les lignes de mot quand le signal de commande flash-ON est à l'état actif (1, dans l'exemple), les signaux d'adresse du bus d'adresse étant alors ignorés.

Pour la sélection en effacement d'une ligne de bit, on prévoit un transistor d'effacement connecté entre chaque ligne de bit et la masse, ledit transistor d'effacement étant commandé sur sa grille par la sortie du circuit retardateur placé en amont de la ligne de bit. Le transistor d'effacement de la première ligne de bit y0 à effacer, TE0 dans l'exemple peut lui être commandé directement par le signal de commande d'effacement flash-ON ou par un circuit retardateur placé en amont, noté R0 dans l'exemple et représenté en pointillé sur la figure 2.

Les autres transistors d'effacement, TE1 à TE7 dans l'exemple, sont respectivement commandés sur leurs grilles par les sorties flashl à flash7 des circuits retardateurs R1 à R7 placés chacun en amont du transistor d'effacement correspondant.

Ainsi, chaque transistor d'effacement est successivement activé quand l'effacement du groupe de cellules précédent est terminé. Les circuits retardateurs sont dimensionnés pour introduire un retard correspondant au temps maximal nécessaire pour l'effacement du groupe précédent. En pratique on propage le signal d'effacement de la première ligne de bit à la dernière, et le cas échéant du premier demi-plan au deuxième, pour obtenir l'effacement complet de la mémoire.

De préférence, les groupes de cellules sont tous équivalents (c'est à dire qu'ils comportent le même nombre de cellules mémoires) et les circuits retardateurs sont tous identiques.

Bien qu'il ne soit pas nécessaire pour la mise en oeuvre de l'effacement séquentiel selon l'invention, le circuit retardateur R0 associé au premier groupe de cellules (ligne y0) permet d'avoir une structure identique pour tous les groupes de cellules. On a ainsi une même charge partout, ce qui est préférable. Pour ces mêmes raisons et aussi pour la simplicité de la mise en oeuvre qui en découle, les groupes de cellules selon l'invention comportent de préférence le même nombre de cellules mémoires.

On notera que tant que le signal de commande en effacement est actif, tous les transistors d'effacement activés restent actifs, même s'ils ne consomment plus de courant une fois l'effacement de leur groupe de cellules associé réalisé. Le signal flash-ON pourrait être un signal correspondant au moins à la durée d'effacement d'un groupe de cellules, avec des circuits retardateurs adaptés pour propager sans déformation cette impulsion.

Mais il est préférable que la fin du niveau actif du signal flash-ON soit générée une fois toute la mémoire effacée, c'est à dire après l'effacement du dernier groupe de cellules.

Aussi prévoit-on un dernier circuit retardateur R8 situé en aval du dernier groupe de cellules à effacer, pour fournir un signal de commande de fin d'effacement flash-END, qui permet de désactiver le signal de commande d'effacement flash-ON.

Ce principe permet d'avoir un effacement très sûr, particulièrement adapté aux exigences de sécurité des applications de type "smart card".

Les circuits retardateurs sont dimensionnés pour prendre en compte les variations dues à la température, à la tension d'alimentation ou à la dispersion des caractéristiques, en sorte que le retard qu'ils induisent soit toujours supérieur au temps d'effacement d'un groupe de cellules.

Le signal de commande d'effacement flash-ON est généré sur détection d'évènements bien déterminés. En pratique, la mise sous-tension du circuit mémoire ou la détection d'anomalies par un circuit 8 de gestion de capteurs de sécurité, entraîne la génération de ce signal flash-ON, comme représenté à la figure 2. Le signal flash-ON est généré à partir du circuit 7 de mise sous-tension du circuit mémoire, qui, sur détection d'une montée de l'alimentation (sur la borne Vcc) ou réception d'un signal d'alarme (ALARM) du circuit 8 de gestion des capteurs, génère un signal d'initialisation POR du circuit mémoire. Ce signal (ou son inverse selon son niveau actif) est utilisé pour générer un signal d'impulsion noté flash-RQ, appliqué sur l'entrée de mise à 1 (S) d'une bascule RS. Quand ce signal flash-RQ présente un front montant d'impulsion, la sortie Q passe à un. Cette sortie Q est utilisée comme signal de commande d'effacement flash-ON. Le signal flash-RQ le fait passer à son niveau actif.

Le signal flash-END est lui appliqué sur l'entrée de mise à zéro de la bascule RS, pour faire repasser le signal flash-ON à son niveau passif. On prévoit de préférence que la bascule peut être ré-initialisée par le signal POR d'initialisation à la mise sous tension. En pratique, on prévoit une porte OU qui reçoit en entrées les signaux POR et flash-END et dont la sortie est appliquée sur l'entrée de mise à zéro (R) de la bascule.

D'autres réalisations sont bien sûr possibles, fonction notamment de l'architecture du circuit mémoire auquel on veut appliquer l'invention.

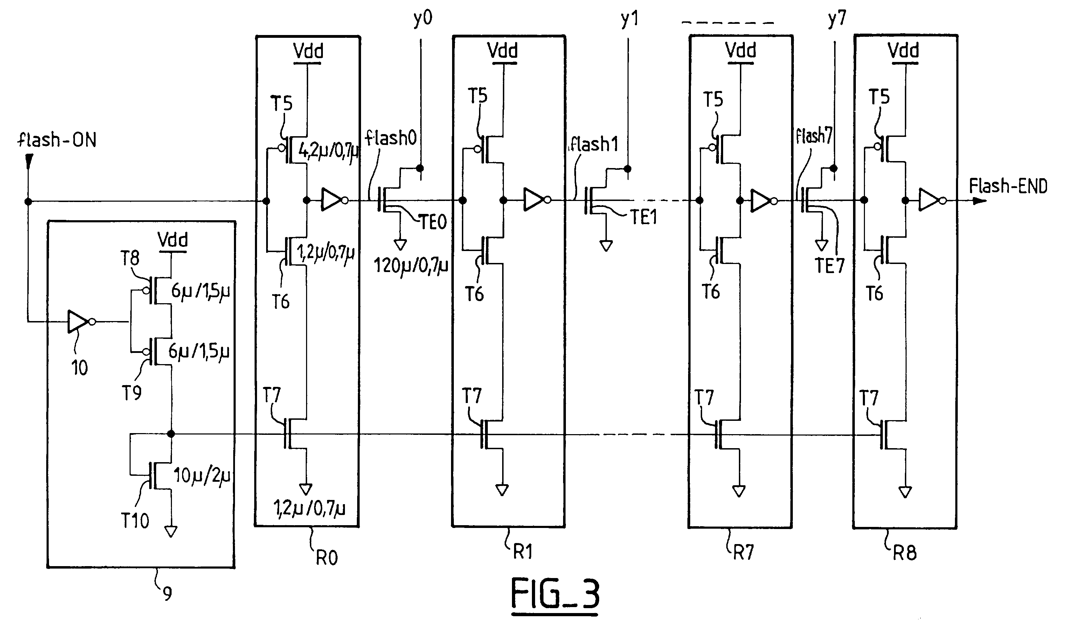

La figure 3 détaille un exemple de circuit 6 de propagation du signal de commande d'effacement flash-ON et de génération du signal de commande de fin d'effacement flash-END.

Le circuit 6 de propagation comprend ainsi un circuit retardateur par groupe de cellules pour propager le signal de commande d'effacement flash-ON de groupe en groupe et un circuit retardateur supplémentaire après le dernier groupe de cellules pour générer le signal de fin d'effacement flash-END.

Chaque circuit retardateur comprend dans l'exemple un premier inverseur CMOS avec un premier transistor MOS de type P T5 et un deuxième transistor MOS de type N T6 dont les grilles reliées ensemble forment la sortie, la source du transistor N étant reliée à la masse par un transistor MOS de même type N T7, pour imposer un courant calibré dans la branche, et retarder ainsi de manière contrôlée le basculement de l'inverseur.

Le premier inverseur est suivi d'un deuxième inverseur pour rendre la polarité du signal d'entrée.

Les transistors T7 de charge des circuits retardateurs sont polarisés par un même circuit de polarisation 9. Dans l'exemple, ce circuit de polarisation 9 est un circuit à miroir de courant activé par le signal de commande flash-ON. Il comprend un inverseur 10 pour commander la grille de deux transistors de type P T8 et T9 reliés en série entre la tension d'alimentation et le drain d'un transistor MOS de type N T10 ayant sa grille reliée à son drain, et sa grille reliée à la grille de chaque transistor de charge. Le courant déterminé circulant dans la branche de polarisation est ainsi recopié dans la branche de chaque circuit retardateur. Ce courant est fonction des caractéristiques de la branche du circuit de polarisation, à savoir, les géométries des transistors et leur type enrichi ou déplété. Le circuit de polarisation 10 est ainsi dimensionné en fonction du retard minimum que l'on veut avoir entre chaque groupe de cellules. Il dépend donc des caractéristiques technologiques des cellules de la mémoire considérée.

On a déjà indiqué que le circuit retardateur R0 pour l'effacement du premier groupe n'est pas obligatoire en principe. Il permet d'avoir une identité de structure pour tous les groupes de cellules de la mémoire, ce qui est de préférence recherché. Mais dans les circuits où l'on cherche à minimiser au maximum le nombre d'éléments (gain de place) ou bien pour lesquels on recherche une durée d'effacement global la plus courte possible, on peut le supprimer.

Le circuit retardateur R8 pour la génération du signal de commande de fin d'effacement vaut pour un signal flash-ON qui reste au niveau actif tant que l'on n'agit pas pour le faire repasser à son niveau passif. Il n'est pas nécessaire si on choisit un signal flash-ON de type impulsionnel avec une durée calibrée correspondant à la durée maximale d'effacement d'un groupe de cellules, bien que ce choix entraîne une circuiterie de propagation plus complexe.

De préférence, les circuits retardateurs utilisent dans l'inverseur un transistor T5 de type P pour le basculement niveau bas vers niveau haut de la sortie, parce que dans ces conditions, un tel transistor bascule plus vite, ce qui permet d'arrêter l'effacement le plus rapidement possible.

En pratique, si on a une ligne de bit de 128 cellules par groupe à effacer, le transistor d'effacement de type N aura des dimensions W/L de l'ordre de 120µ /0.7µ en technologie CMOS à 0.7µ, pour pouvoir passer un courant maximum qui est de 25 milliampères d'après les expérimentations.

La décharge d'une ligne de bit se fait alors en 3 nanosecondes maxi sous 5,5 volts d'alimentation et 25 nanosecondes maxi sous 1.8 volts d'alimentation. Avec une alimentation à 5,5 volts, les circuits retardateurs seront dimensionnés pour que le retard induit soit de l'ordre de 4 nanosecondes.

Pour 16 cellules, le courant maximum descend à 15 milliampères, et un transistor N de 15µm/0.7µm devient suffisant. Dans l'exemple de réalisation décrit en relation avec les figures 2 et 3, on a choisit la technologie MOS. Mais l'invention est réalisable en toute technologie.

## Revendications

1. Procédé d'effacement d'une mémoire RAM statique, caractérisé en ce qu'il consiste à organiser la mémoire en groupes de cellules et à effacer séquentiellement tous les groupes de cellules de ladite mémoire en propageant de manière contrôlée un signal d'effacement (flash-ON) de groupe en groupe.

2. Procédé d'effacement selon la revendication 1, caractérisé en ce que la propagation de manière contrôlée consiste à imposer un retard déterminé entre deux groupes de cellules successifs, le retard entre deux groupes successifs étant au minimum égal à la durée maximum d'effacement du premier groupe.

3. Procédé d'effacement selon la revendication 1 ou 2, caractérisé en ce que les groupes de cellules comportent le même nombre de cellules.

4. Procédé d'effacement selon l'une des revendications précédentes la mémoire étant organisée matriciellement en lignes de bit et lignes de mot, caractérisé en ce qu'un groupe de cellules consiste en une ou plusieurs lignes de bit.

5. Mémoire RAM statique en circuit intégré caractérisée en ce qu'elle est découpée en groupes de cellules et en ce qu'elle comprend un transistor (TE0) d'effacement par groupe de cellules et des circuits retardateurs (R0,...,R8), les transistors d'effacement (TE0,...,TE7) étant commandés sur leurs grilles à partir d'un signal d'effacement (flash-ON) qui se propage de grille en grille au travers des circuits retardateurs.

6. Mémoire RAM statique en circuit intégré selon la revendication 5, organisée matriciellement en lignes de bit et lignes de mot, caractérisée en ce qu'un groupe de cellules comprend au moins une ligne de bit (y0), chaque ligne de bit (y0) étant connectée à un transistor d'effacement correspondant (TE0), et en ce qu' 'elle comprend des moyens (DEC-X, flash-ON) pour sélectionner en effacement toutes les lignes de mot.

7. Mémoire RAM statique selon la revendication 5 ou 6, caractérisée en ce qu'un circuit retardateur (R1) impose un temps de propagation du signal d'effacement entre les grilles de deux transistors d'effacement successifs (TE0, TE1) au moins égal au temps d'effacement maximum du groupe (y0) des cellules connecté au premier (TE0) des deux transistors.

8. Mémoire RAM statique selon l'une quelconque des revendications 5 à 7, caractérisée en ce que chaque groupe de cellules comprend le même nombre de cellules.

9. Mémoire RAM statique selon l'une quelconque des revendications 5 à 8, caractérisée en ce qu'un circuit retardateur comprend un montage à inverseur (T5, T6) et limiteur de courant (T7).

10. Mémoire RAM statique selon la revendication 8 prise en combinaison avec la revendication 9, caractérisée en ce que le limiteur de courant (T7) de chaque circuit retardateur est commandé par un même circuit (9) de polarisation à miroir de courant, pour imposer le même courant dans la branche de sortie de l'inverseur.

11. Mémoire RAM statique selon l'une quelconque des revendications 5 à 10, caractérisée en ce qu'elle comprend un dernier circuit retardateur (R8) après la grille du transistor d'effacement (TE7) du dernier groupe de cellules mémoires à effacer (y7) pour générer un signal de commande de fin d'effacement (flash-END).

## Claims

1. Method of erasing a static RAM memory, characterised in that it consists of organising the memory in groups of cells and sequentially erasing all the groups of cells in the said memory by propagating an erase signal (flash-ON) in a controlled fashion from group to group.

2. Erasure method according to Claim 1, characterised in that the controlled propagation consists of imposing a given delay between two successive groups of cells, the delay between two successive groups being at a minimum equal to the maximum duration of erasure of the first group.

3. Erasure method according to Claim 1 or 2, characterised in that the groups of cells include the same number of cells.

4. Erasure method according to one of the preceding claims, the memory being organised in a matrix in bit lines and word lines, characterised in that a group of cells consists of one or more bit lines.

5. Integrated circuit static RAM memory characterised in that it is divided into groups of cells and in that it comprises a transistor (TEO) for erasing by groups of cells and delay circuits (R0, ..., R8), the erasure transistors (TE0, ..., TE7) being controlled at their gates from a erasure signal (flash-ON) which propagates from gate to gate through the delay circuits.

6. Integrated circuit static RAM memory according to Claim 5, organised in a matrix in bit lines and word lines, characterised in that a group of cells comprises at least one bit line (y0), each bit line (y0) being connected to a corresponding erasure transistor (TE0), and in that it comprises means (DEC-X, flash-ON) for selecting, in erase mode, all the word lines.

7. Static RAM memory according to Claim 5 or 6, characterised in that a delay circuit (R1) imposes a propagation time for the erasure signal between the gates of two successive erasure transistors (TE0, TE1) at least equal to the maximum erase time of the group (y0) of cells connected to the first (TE0) of the two transistors.

8. Static RAM memory according to any one of Claims 5 to 7, characterised in that each groups of cells comprises the same number of cells.

9. Static RAM memory according to any one of Claims 5 to 8, characterised in that a delay circuit comprises an arrangement with an inverter gate (T5, T6) and a current limiter (T7).

10. Static RAM memory according to Claim 8 taken in combination with Claim 9, characterised in that the current limiter (T7) of each delay circuit is controlled by the same biasing circuit (9) with current mirror, for imposing the same current in the output arm of the inverter gate.

11. Static RAM memory according to any one of Claims 5 to 10, characterised in that it comprises a last delay circuit (R8) after the gate of the erasure transistor (T7) of the last group of memory cells to be erased (y7) in order to generate an end of erasure control signal (flash-END).

## Patentansprüche

1. Verfahren zum Löschen eines statischen RAM-Speichers,
**dadurch gekennzeichnet,** daß
es umfaßt: Organisieren des Speichers in Gruppen von Zellen und sequentielles Löschen jeder der Gruppe von Zellen des Speichers, indem auf kontrollierte Art und Weise ein Löschsignal (flash-ON) von Gruppe zu Gruppe weitergegeben wird.

2. Verfahren zum Löschen nach Anspruch 1,
dadurch gekennzeichnet, daß
das Weitergeben auf kontrollierte Art und Weise darin besteht, eine bestimmte Verzögerung zwischen zwei aufeinanderfolgenden Gruppen von Zellen zu bewirken, wobei die Verzögerung zwischen zwei aufeinanderfolgenden Gruppen mindestens gleich der maximalen Dauer des Löschens der ersten Gruppe ist.

3. Verfahren zum Löschen nach Anspruch 1 oder 2,
dadurch gekennzeichnet, daß
die Gruppen von Zellen die gleiche Anzahl von Zellen umfassen.

4. Verfahren zum Löschen nach einem der vorangehenden Ansprüche, wobei der Speicher matrixförmig in Bitleitungen und Wortleitungen unterteilt ist,
dadurch gekennzeichnet, daß
eine Gruppe von Zellen aus einer oder mehreren Bitleitungen besteht.

5. Statischer RAM-Speicher in Form eines integrierten Schaltkreises,
dadurch gekennzeichnet, daß
er unterteilt ist in Gruppen von Zellen und daß er einen Löschtransistor (TEO) pro Zellengruppe und Verzögerungschaltkreise (RO,... R9) umfaßt, wobei die Löschtransistoren (TEO,..., TE7) über ihre Gates durch ein Löschsignal (flash-ON) gesteuert werden, das sich von Gate zu Gate über Verzögerungschaltkreise fortpflanzt.

6. Statischer RAM-Speicher in Form eines integrierten Schaltkreises nach Anspruch 5, der matrixförmig in Bitleitungen und Wortleitungen unterteilt ist,
dadurch gekennzeichnet, daß
eine Gruppe von Zellen wenigstens eine Bitleitung (y0) umfaßt, wobei jede Bitleitung (y0) mit einem entsprechenden Löschtransistor (TEO) verbunden ist, und daß er Mittel (DEC-X, flash-ON) umfaßt, um zum Löschen alle Wortleitungen auszuwählen.

7. Statischer RAM-Speicher nach Anspruch 5 oder 6,
dadurch gekennzeichnet, daß
ein Verzögerungsschaltkreis (R1) eine Zeit zur Fortpflanzung des Löschsignals zwischen den Gates der zwei aufeinanderfolgenden Löschtransistoren (TEO, TE1) bewirkt, die wenigstens gleich der maximalen Zeit zum Löschen der Gruppe (y0) von Zellen ist, die mit dem ersten (TEO) der zwei Transistoren verbunden ist.

8. Statischer RAM-Speicher nach einem der Ansprüche 5 bis 7,
dadurch gekennzeichnet, daß
jede Gruppe von Zellen die gleiche Zahl an Zellen umfaßt.

9. Statischer RAM-Speicher nach einem der Ansprüche 5 bis 8,
dadurch gekennzeichnet, daß
ein Verzögerungsschaltkreis eine Invertierervorrichtung (T5, T6) und einen Strombegrenzer (T7) umfaßt.

10. Statischer RAM-Speicher nach Anspruch 8 in Verbindung mit Anspruch 9,
dadurch gekennzeichnet, daß
der Strombegrenzer (T7) von jedem Verzögerungsschaltkreis durch einen gleichen Polarisationsschaltkreis (9) mit Stromspiegel gesteuert wird, um den gleichen Strom in dem Ausgangszweig des Invertierers hervorzurufen.

11. Statischer RAM-Speicher nach einem der Ansprüche 5 bis 10,
dadurch gekennzeichnet, daß
er einen letzten Verzögerungsschaltkreis (R8) nach dem Gate des Löschtransistors (TE7) der letzten Gruppe von Speicherzellen, die zu löschen sind (y7), zum Erzeugen eines Steuersignals zum Beenden des Löschens (flash-END) umfaßt.
